Europäisches Patentamt

(19) European Patent Office

Office européen des brevets

(11) Publication number : **0 627 630 A2**

(12) **EUROPEAN PATENT APPLICATION**

(21) Application number : 94302247.5

(22) Date of filing : 29.03.94

(51) Int. Cl.$^5$ : **G01R 15/02**, G01R 19/10

(30) Priority : 07.04.93 US 43903

(43) Date of publication of application :
07.12.94 Bulletin 94/49

(84) Designated Contracting States :
CH DE ES FR GB GR IT LI

(71) Applicant : **GENERAL ELECTRIC COMPANY**
1 River Road
Schenectady, NY 12345 (US)

(72) Inventor : **Coburn, David Carl**
44 Pinwood Drive
Somersworth, New Hampshire 03878 (US)

(74) Representative : **Lupton, Frederick et al**
LONDON PATENT OPERATION,
G.E. TECHNICAL SERVICES Co. INC.,
Essex House,
12/13 Essex Street
London WC2R 3AA (GB)

(54) **Differential current sensing method and apparatus.**

(57) A current sensor includes first and second conductors and an annular current comparator magnetically coupled to the first and second conductors for producing an output signal related in magnitude and phase to an input current. The first and second conductors have first and second-predetermined resistances, respectively, for conducting first and second portions of the input current along first and second directions, respectively. The first direction is substantially opposite the second direction within a bore of the annular current comparator. A current is induced in the annular current comparator, preferably a toroidal winding, in relation to the current difference between the first and second portions of the input current. Secondary windings, preferably feedback and sense secondary windings, are wound about and magnetically coupled to the annular current comparator for producing an output signal responsive to the current induced within the annular current comparator while preventing the annular current comparator from being saturated.

FIG. I.

Field of the Invention

The present invention relates current sensors for sensing a current, and, more particularly, to current sensors for producing an output signal related to the sensed input current.

Background of the Invention

Many electrical devices, such as induction or electronic type watthour meters for metering electric power and energy usage, require current sensors for sensing the line current and producing an output signal related to the line current. These devices demand sensors which are accurate for a wide range of line currents.

For many years, induction type watthour meters have been used to measure energy consumption by individual electrical energy users, with consumption measured in kilowatt hours. Induction type watthour meters typically have separate voltage and current coils with a rotating disk driven by a combination of fluxes from the coils. Conventional induction watthour meters include a current sensing circuit in which the conductor carrying the line current is wrapped about in an iron core to form a current coil. A magnetic flux is created in the iron core due to the current flowing in the conductor. The magnetic flux in the iron core, in combination with the magnetic flux from a similar voltage coil, rotates a disk at a rate related to the customer's electrical energy consumption.

Current transformers are used in conjunction with the above-described current sensing circuits to scale down relatively large line currents, i.e., greater than about 320 amperes, since the number of turns about the iron core required to properly scale such relatively large line currents would become prohibitively large. The current transformer is disposed between the line conductor and the current sensing circuit. While such current transformers are generally rated to have a nominal current in their secondary winding of five amperes, approximately twenty amperes of secondary current may usually be drawn without exceeding the thermal rating of the transformer. Thus, even with the introduction of a current transformer between the conductor and the current sensing circuit, induction type watthour meters must still be capable of measuring relatively large currents, such as twenty amperes.

Such relativity large currents however, cannot be accurately sensed by electronic watthour meters which typically utilize electronic or integrated circuits for measuring the current and voltage usage of individual electrical energy customers. The integrated circuits are designed to accept and measure small signal levels, such as typically less than 5mA and less than 5 volts. The current sensors in electronic watthour meters, therefore, must have a large transformation ratio to scale the relatively large line currents to the relatively small input levels accepted by the sensor's integrated circuits.

In order to produce such relatively small output signals, typical current transformers would become prohibitively large and expensive. This increased size and expense is due, in part, to the requirement that the ampere turns of the primary and secondary windings must be equal for proper operation. The number of windings must also be selected such that the maximum input line current is scaled to a value less than the 5mA current limit for the integrated circuit. Since line currents typically vary from 0.5A to 200 A, the transformation ratio of typical current transformers would need to be approximately 100,000:1 to convert 200A to a value of less than 5mA. A transformation ratio of 100,000:1 would require a relatively large number of windings and a prohibitively large and expensive current transformer.

In addition to being prohibitively large and expensive, the magnetic cores of typical current transformers saturate if the alternating current ("AC") flowing in a line conductor is superimposed upon a DC current. The DC current, and thus the saturation of the magnetic core, is generally due to half-wave rectification of AC current signals by various electrical devices connected to the line conductor or by persons intentionally superimposing DC current components upon the line conductor to commit meter fraud by preventing proper current sensing and electrical energy consumption measurement.

Furthermore, typical current transformers produce an external magnetic field which may affect adjacent electrical devices, such as the other current transformers in a polyphase watthour meter. The current transformation in typical current transformers may also be adversely affected by incident magnetic fields from external sources such as the adjacent current sensors employed in polyphase watthour meters.

An alternative current sensor to such typical current transformers is provided in U.S. Patent No. 4,182,982 to Wolf et al. which issued January 1980 and U.S. Patent No. 4,492,919 to Milkovic which issued January 1985 (hereinafter the '982 and '919 patents, respectively). The '982 and '919 Patents disclose the division of a line conductor into one or more main shunt paths and a parallel auxiliary shunt path having different cross-sectional areas. The current divides between these two shunt paths substantially in proportion to the cross-sectional areas of the two paths. The auxiliary shunt path passes through the bore of a toroidal magnetic core. A current transformer is formed by the combination of the toroidal magnetic coil, the auxiliary shunt path which forms a one turn primary winding and a winding of many turns wound about the toroidal magnetic core which forms a secondary winding.

The shunt paths disclosed in the '982 and '919 patents are comprised of copper whose resistance varies substantially in response to temperature fluctuations since copper has a significant thermal coefficient of resistance. In addition, the cross-sectional areas of the primary shunt path and the auxiliary shunt path may become prohibitively large and small, respectively, in order to properly scale the line current over the large range of potential line currents. Furthermore, the parallel primary and auxiliary shunt paths are affected not only by magnetic fields produced by external sources, but also by magnetic fields produced by the current flowing in the other shunt path. For example, the current in the primary shunt path is affected by the magnetic field produced by the current flowing in the auxiliary shunt path. In addition, the magnetic coupling between the parallel conductors in the current divider produces a mutual inductance between the two parallel conductors. This inductance transforms the relatively simple resistance divider to a complex impedance divider with the phase shift of the current flowing in the main shunt path and parallel auxiliary path dependant on the inductance. Since adequate metering accuracy demands that both the magnitude and the phase angle of the scaled output signal of the current sensor accurately reflect the magnitude and the phase angle of the line current, such phase shifts in the parallel shunt paths, which, in turn, are reflected in the output signal of the current sensor impair the metering accuracy.

A coaxial current sensor is disclosed in U.S. Patent No. 5,066,904 to Bullock which issued on November 19, 1991 and is assigned to the assignee of the present invention, the disclosure of which is incorporated herein by reference. The coaxial current sensor divides the current flowing in the line conductor between two coaxially-arranged conductors. The center conductor is directed through the bore of a magnetic toroidal core to induce current flow in a magnetic toroidal core.

Sense and feedback secondary windings are also wound about the toroidal magnetic core. A current is induced in the sense winding due to and in proportion to the current in the magnetic toroidal core. An amplifier responsive to the current induced in the sense secondary winding provides a control or compensation signal to the feedback secondary winding. The current flow in the feedback winding due to the control signal induces another current in the toroidal core, substantially equal in magnitude and opposite in direction to the current induced by the current flow in the central conductor. The resultant net current in the magnetic toroidal core is approximately zero in a steady-state condition with no variations of the input current. Any current in the magnetic toroidal core due to changes in the input current is thus induced substantially linearly in relation to the current flowing in the center conductor due to the maintenance otherwise of a net current of approximately zero in the toroidal core at steady-state which prevents the core from being saturated due either to excessive AC line currents or superimposed DC currents. The feedback second secondary winding also produces the output current which is proportional to the current flowing through the center conductor.

While the coaxial current sensor represents a great advance the art of sensing and scaling line currents, particularly for use in watthour meters, further improvements are desirable. In particular, the coaxial conductors may magnetically couple due to the magnetic field produced by the current flowing in each conductor and the resulting self-inductance in the other conductor. This mutual inductance may introduce a phase shift or error in the resulting scaled outlet current. In addition, the coaxial current sensor is of relatively complex design and accordingly may be expensive to fabricate. Furthermore, since the ratio at which the current divides between the coaxial conductors depends upon the cross-sectional areas of the conductors, the ratio of current division may be adjusted by trimming the resistances of the conductors, such as by drilling, a portion of the material from a first end of the conductors. This removal or drilling of the conductors may be difficult due to the alignment and size of the conductors.

Thus, while it would be desirable to have a current sensor for producing an output current having a magnitude and phase angle related to an input current, particularly for use in sensing line currents in electronic watthour meters, current sensors still suffer from a number of deficiencies, including magnetic coupling between parallel conductors of the current sensor which results in phase shifts in the output signal. In particular, it would be desirable to have a current sensor which produces an output signal having a magnitude less than approximately 5mA and is related to the magnitude and phase of the input current for use with electronic watthour meters which utilize electronic or integrated circuits for measuring a customer's electrical energy consumption.

Summary of the Invention

It is therefore a feature of the invention to Provide an improved method and apparatus for sensing an input current.

It is another feature of the invention to Provide an improved method and apparatus for sensing an input current signal and producing a related output current signal.

It is a further feature of the invention to Provide an improved method and apparatus for sensing an input current signal and producing an output current signal related in magnitude and phase to the input current signal.

There is provided, according to the invention, by a differential current sensor including first and second conductors and a sensing means magnetically coupled to the first and second conductors. The first conductor, preferably a first resistor, has a first predetermined resistance and conducts a first portion of the input current. The second conductor, preferably a second resister, has a second predetermined resistance and conducts a second portion of the input current. The input current, thus, divides between the first and second conductor in an inverse relation to the first and second predetermined resistances. The sensing means, magnetically coupled to the first and second conductors, produces an output signal related to the current *differential* between the first and second portions of the input current. This output current may be detected by an integrated circuit in an electronic watthour meter to accurately measure a consumer's electrical energy consumption.

The sensing means is preferably an annular current comparator and is more preferably a toroidal winding having a bore extending therethrough. Both the first and second conductors extend through the bore of the toroidal winding and, in combination, form a single turn primary winding for a current transformer whose core is formed by the toroidal winding. The first conductor preferably conducts the first portion of the input current along a first direction while the second conductor conducts the second portion of the input current along a second direction. The first direction is substantially opposite that of the second direction within the bore of the toroidal winding. The first and second conductors are also substantially parallel within the bore of the toroidal winding.

The first and second portions of the input current induce a current in the toroidal winding related to the current difference therebetween since the first and second portions of the input current are flowing in opposite directions within the bore of the toroidal winding. By sensing the input current with magnetically induced currents, the output signal is isolated from the input current so as to suppress voltage transients in the input current and to protect the current sensor.

The sensing means also preferably includes means for magnetically sensing the current induced within the toroidal winding. The means for magnetically sensing the current induced within the toroidal winding preferably includes a secondary winding wound about and magnetically coupled to the toroidal winding for producing the output signal. The means for magnetically sensing the current in the toroidal winding more preferably includes a feedback secondary winding and a sense secondary winding with each secondary winding wound about and magnetically coupled to the toroidal winding with an amplifier circuit disposed therebetween. The combination of the feedback and sense secondary windings and the associated amplifier circuit produces the output signal which is related to and preferably proportional to the magnitude and phase of the input current signal. The secondary windings and the associated amplifier circuit also induce a second current within the toroidal winding equal in magnitude and opposite in direction to that induced by the current difference between the first and second portions of current to prevent the toroidal winding from being saturated.

The resistances of the first and second conductors depend generally upon their respective cross-sectional areas. Their respective resistances may be readily trimmed or adjusted by notching the conductors. The resistance of the resulting notched conductor varies in direct relation to the size of the notch.

The first and second conductors preferably extend between first and second legs such that a first end of both the first and second conductors is connected to the first leg and a second end of both the first and second conductors is connected to the second leg. The first conductor or wire preferably extends from the first leg to the bore of the toroidal winding along a first face of the toroidal winding and from the bore of the toroidal winding to the second leg along a second face of the toroidal winding. The second conductor or wire preferably extends from the first leg to the bore of the toroidal winding along the second face of the toroidal winding and from the bore of the toroidal winding to the second leg along the first face of the toroidal winding. The first and second legs are preferably designed to mate with and make electrical contact with a standard watthour meter base.

The current sensing method and apparatus of this invention allows an input current signal to be sensed and an output current signal produced which is related to the magnitude and phase of the input current signal based upon the current difference between the first and second conductors between which the input current divides. In addition, the current sensor of the present invention significantly reduces or eliminates errors in the phase of the output signal due to any mutual inductance between the first and second conductors.

Brief Description of the Drawings

Figure 1 is a perspective view of a current sensor according to the present invention.

Figure 2 is a cross-sectional view of the current sensor of Figure 1 taken along line 2-2' of Figure 1.

Figure 3 is an enlarged fragmentary perspective view of a notch for trimming or adjusting the resistance of a conductor of the present invention.

Figure 4 is an electrical schematic of the current sensor of Figure 1.

Figure 5 is a schematic view of a current sensor according to the present invention including the toroidal winding and sense and feedback secondary windings.

Description of the Preferred Embodiment

The present invention now will be described more fully hereinafter with reference to the accompanying drawings, in which a preferred embodiment of the invention is shown. This invention may however be embodied in many different forms and should not be construed as limited to the embodiments set forth herein; rather, this embodiment is provided so that this disclosure will be thorough and complete and will fully convey the scope of the invention to those skilled in the art. Like numbers refer to like elements throughout.

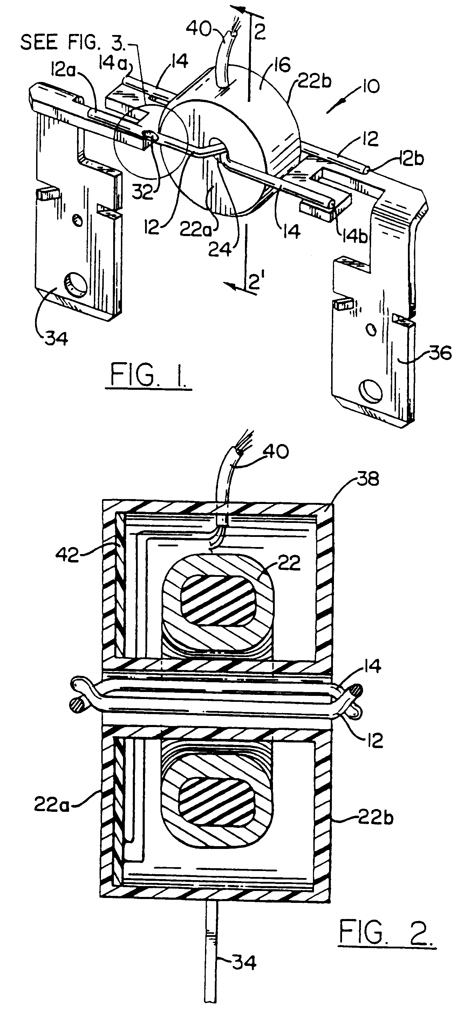

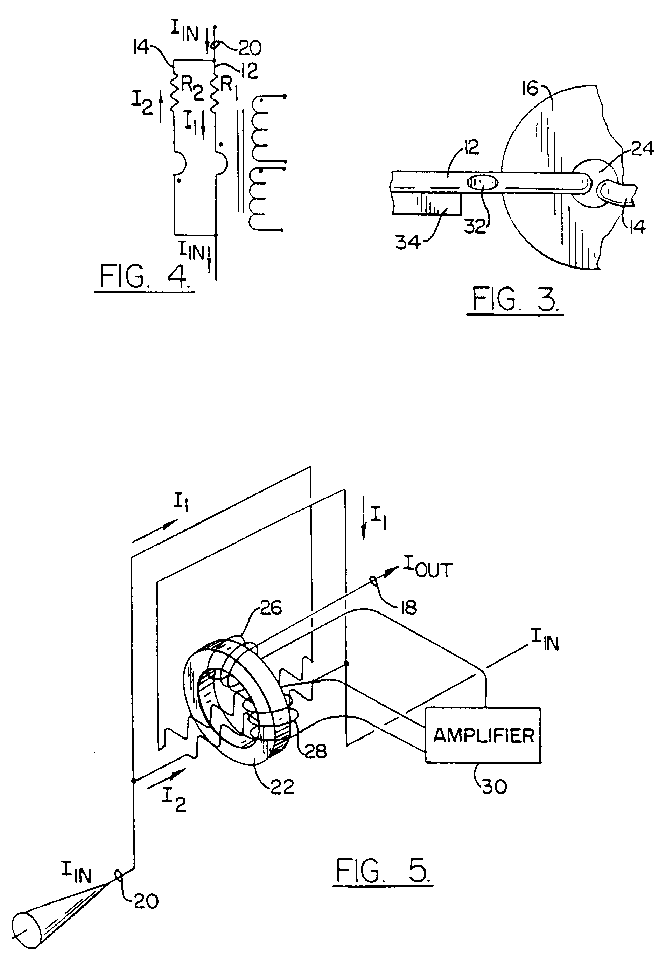

Referring now to Figures 1 and 5, a current sensor 10 according to the present invention is illustrated. The current sensor 10 includes a first conductor 12 and a second conductor 14 as well as sensing means 16 magnetically coupled to the first and second conductors for producing an output signal 18 related in phase and magnitude to an input current 20. As shown schematically in Figures 4 and 5, the first conductor 12, preferably a first resister, has a first predetermined resistance $R_1$ for conducting a first portion $I_1$ of the input current $I_{in}$. The second conductor 14, preferably a second resister, has a second predetermined resistance $R_2$ for conducting a second portion $I_2$ of the input current $I_{in}$. The input current 20 thus divides between the first and second conductors in an inverse relation to the individual resistances of the first and second conductors. In Particular, the first and second portions of the input current 20 are:
$$I_1 = I_{in} (R_2 /(R_1 + R_2))$$
$$I_2 = I_{in} (R_1 /(R_1 + R_2))$$
The sensing means 16 produces an output signal 18 related to, and preferably proportional to, the current difference between the first and second portions of the input current and magnetically coupled to the first and second conductors. Preferably, the sensing means 16 includes an annular current comparator and more preferably includes a toroidal winding 22 having a bore 24 extending therethrough as illustrated in Figure 2. The toroidal winding 22 is generally comprised of a large number of individual windings of a conductive material such as iron.

Referring now to Figure 4, the first conductor 12 conducts the first portion $I_1$ of the input current along a first direction while the second conductor 14 conducts the second portion $I_2$ of the input current along a second direction. The first direction is substantially opposite the second direction within the bore 24 of the toroidal winding 22. In addition, the first and second conductors are substantially parallel within the bore 24 of the toroidal winding 22 as shown in Figure 2.

Both the first and second portions of the input current flowing in the first and second conductors, respectively, induce a current to flow in the toroidal winding 22. Due to the opposite directions of flow of the first and second portions of input current, the resulting current induced within the toroidal winding 22 is the difference between the individual currents induced by the first and second portions of the input current. Thus, the resulting current induced within the toroidal winding 22 is related to the current difference between the first and second portions of the input current. By sensing the input current 20 based upon magnetically induced currents, the current sensor 10 provides isolation between its output signal 18 and the line current to suppress high voltage transients on the input current 20 and to protect the current sensor 10.

Since the first and second conductors are substantially parallel within the bore 24 of the toroidal winding 22, the mutual inductances therebetween due to the magnetic fields produced by the flow of current through the respective conductors are approximately equal in magnitude and opposite in polarity. Thus, the resulting mutual inductance between the first and second conductors is significantly reduced or eliminated. The phase angle of the output signal 18 therefore more accurately reflects the phase angle of the input current 20 due to the significantly reduced or eliminated mutual inductances.

The sensing means 16 also preferably includes means for magnetically sensing the current induced within the toroidal winding 22. The means for magnetically sensing the current within the toroidal winding 22 preferably includes a secondary winding wound about and magnetically coupled to the toroidal winding 22 for producing the output signal 18.

More preferably, the means for magnetically sensing the current within the toroidal winding 22 includes a feedback secondary winding 26, a sense secondary winding 28 and an amplifier circuit 30 as illustrated in Figure 5. A current is induced in the sense winding 28 due to and in proportion to the current in the magnetic toroidal winding 22. The amplifier circuit 30 is responsive to the current induced in the sense winding 28 and provides a control or compensation signal to the feedback winding 26. The current flow in the feedback winding 26 due to the control signal produces a current in the toroidal winding 22 which is substantially equal in magnitude and opposite in direction to the current induced by the current differential between the first and second portions of the input current. The resulting net current in the toroidal winding 22 in a steady-state condition is approximately zero. Any current induced in the toroidal core 22 due to changes in the input current 20 is thus induced substantially linearly in relation to the current differential between the first and second portions of the input current since the maintenance of a minimal, steady-state net current prevents the toroidal core 22 from saturating. The feedback secondary winding 26 also provides the output signal 18 which is related to, and preferably proportional to, the magnitude and phase of the input current signal 20.

In order to obtain the large transformation ratios required by electronic watthour meters which utilize integrated circuits, two distinct transformations which define two transformation ratios are provided by the current sensor **10** of the present invention. The product of the two transformation ratios is the transformation ratio of the entire current sensor **10** and defines the relationship between the magnitude of the output signal **18** and that of the input current **20**.

In particular, a first transformation ratio is provided by the division of the input current **20** between the first and second conductors. The current division therebetween is defined by the cross-sectional areas and the resistances of the individual conductors. Preferably, the first and second conductors are formed from the same material, preferably an aluminum material, and thus have the same resistivity. In addition, the cross-sectional areas of the first and second conductors are preferably identical. To vary the current division between the first and second conductors, a notch **32** is milled in at least one of the conductors to adjust or trim its resistance and thus decrease the current flowing therethrough as shown in Figure 3. The resistance of the notched conductor varies directly with the size, i.e., the depth and width, of the notch with larger notches creating greater resistance.

In a preferred embodiment, the first conductor **12** is notched such that it conducts approximately 42 1/2% of the input current **20** while the second, unnotched conductor 14 conducts approximately 57 1/2% of the input current. Thus, for an input current of 20 A, the first portion $I_1$ of current flowing through the first conductor **12** is approximately 8.5 A while the second portion $I_2$ of current flowing through the second conductor **14** is approximately 11.5 A. A current differential of 3A therefore exists between the first and second portions of input-current.

The second transformation ratio is provided by the number of secondary windings about the toroidal core **22**. More particularly, the ampere turns for both the primary and secondary side of the current transformer are identical. While the first and second conductors effectively form a single turn primary winding about the toroidal winding **22** which forms the transformer's core, the number of windings of the sense secondary winding **28** may be varied to optimize the output signal **18**. Thus, the product of the single turn primary and the current difference between the first and second portions of current, i.e., 1 turn x (11.5 8.5) A = 3 ampere turns for the above described example, is equal to the product of the number of turns of the sense secondary winding **28** and the output signal **18** produced thereby. Therefore, by increasing the number of turns of the sense secondary winding **28**, the second transformation ratio is increased and the resulting output signal **18** is decreased.

The transformation ratio for the entire current sensor **10**, and thus the relationship between the magnitude of the output signal **18** and input current **20** is a product of the first transformation ratio as defined by the division of the input current **20** between the first and second conductors, and the second transformation ratio based upon the ampere turns relationship between the primary and secondary windings or the toroidal core **22** forming the current transformer.

As shown in Figure 1, the input current **20** is preferably provided by a first leg **34,** typically comprised of copper, to which a first end **12a, 14a** of both the first and second conductors are bonded. The second end **12b, 14b** of the first and second conductors are preferably bonded to a second leg **36**, also preferably formed of copper. The first conductor **12**, typically a wire, preferably extends from the first leg **34** to the bore **24** of the toroidal winding **22** along a first face **22a** of the toroidal winding **22** and from the bore **24** to the second leg **36** along a second face **22b** of the toroidal winding **22**. The second conductor **14**, typically a wire, preferably extends from the first leg **34** to the bore **24** of the toroidal winding **22** along the second face **22b** of the toroidal winding **22** and from the bore **24** to the second leg **36** along the first face **22a** of the toroidal winding **22**. The first and second legs are designed to mate with and electrically connect with the standard electronic watthour base so as to allow measurement of the input line current **20** which is being provided to the customer.

While the Particular configuration of the current sensor **10** may be widely varied, it is preferred that the sensing means **20** be encapsulated by an insulating material **38** to facilitate its operation and longevity. More preferably, this insulating material is a plastic material.

In addition, the wires **40** extending from the encapsulated sensing means **16** in Figures 1 and 2 are connected with the external amplifier circuit **30** (not illustrated). The wires **40** extend to a common printed circuit board **42** on which electrical contact is established between each end of the sense and feedback secondary windings and one of the wires **40**. The amplifier circuit **30** may be encapsulated with the sensing means **16** so as to eliminate the wires **40** extending therefrom without departing from the scope of this invention.

In the drawings and specification, there have been disclosed typical preferred embodiments of the invention and, although specific terms are employed, the terms are used in a generic and descriptive sense only and not for purposes of limitation, the scope of the invention being set forth in the following claims.

## Claims

1. An apparatus for sensing an input current, comprising:

    means for conducting a first portion of said input current;

means for conducting a second portion of said input current; and

sensing means magnetically coupled to said first and second conducting means for producing an output signal related to a current differential between said first and second portions of said input current.

2. The current sensing apparatus according to claim 1, wherein said first conducting means is a first conductor having a first predetermined resistance, wherein said second conducting means is a second conductor having a second predetermined resistance, and wherein said sensing means includes a toroidal winding having a bore extending therethrough.

3. The current sensing apparatus according to claim 2, wherein said sensing means includes a means for magnetically sensing a current induced within said toroidal winding by said current differential between said first and second portions of said input current.

4. The current sensing apparatus according to claim 3, wherein said means for magnetically sensing said current induced in said toroidal winding includes a secondary winding wound about and magnetically coupled to said toroidal winding for producing said output signal.

5. The current sensing apparatus according to claim 2, wherein said first conductor includes a notch whereby the resistance of said first conductor varies in relation to the size of said notch.

6. The current sensing apparatus according to claim 2, wherein said output signal is directly proportional to said current differential between said first and second portions of said input current.

7. The current sensing apparatus according to claim 2, wherein the sum of the magnitude of said first and second input current portions substantially equals the magnitude of said input current.

8. A current sensing apparatus comprising:

a first resistor having a first predetermined resistance for conducting a first portion of said input current along a first direction;

a second resistor having a second predetermined resistance for conducting a second portion of said input current along a second direction; and

an annular current comparator responsive to said first and second portions of said input current for producing an output signal related to said input current; wherein said first and second resistors are disposed through a bore of said current comparator such that said second direction is substantially opposite said first direction.

9. The current sensing apparatus according to claim 8, wherein said annular current comparator includes a toroidal winding having said bore extending therethrough.

10. The current sensing apparatus according to claim 9, wherein said annular current comparator includes means for magnetically sensing a current induced within said toroidal winding by current differential between said first and second portions of said input current.

11. The current sensing apparatus according to claim 10, wherein said means for magnetically sensing said current induced in said toroidal winding comprises:

a sense secondary winding wound about and magnetically coupled to said toroidal winding;

an amplifier means having an input connected to said sense secondary winding and an output; and

a feedback secondary winding wound about and magnetically coupled to said toroidal winding and connected at a first end to said output of said amplifier means, wherein any DC component of current induced in said toroidal winding is substantially eliminated.

12. A current sensing apparatus comprising:

a first leg for conducting an input current;

a first wire connected at a first end to said first leg;

a second wire connected at a first end to said first leg;

a second leg for conducting an output current, said second leg connected to a second end of both said first and second wires;

a toroidal winding having a bore through which both said first and second wires extend.

13. The current sensing apparatus according to claim 12, further comprising a secondary winding wound about said toroidal winding for producing an output signal related to said input current.

14. A method for sensing an input current, comprising the steps of:

dividing said input current into first and second portions having a predetermined ratio therebetween;

sensing a difference in current between said first and second portions; and

producing said output current related to said sensed current differential.

15. The method according to claim 14, wherein the dividing step includes the step of directing said first portion of input current along a first direction and said second portion of input current along a second direction, and wherein the sensing step includes the steps of passing both said first and second portions of current through a bore of a toroidal winding and inducing a current in said toroidal winding directly proportional to said current differential between said first and second portions.

FIG. 1.

FIG. 2.

FIG. 4.

FIG. 3.

FIG. 5.